# EUROPEAN PATENT APPLICATION

(11) **EP 1 378 787 A1**
(43) Date of publication of application: **07.01.2004**
(21) Application number: 03015176.5
(22) Date of filing: 03.07.2003
(51) Int. Cl.: G02F 1/13357

(54) **Lighting system and display**

(30) Priority: 05.07.2002 JP 2002197973
(71) Applicant: KABUSHIKI KAISHA TOYOTA JIDOSHOKKI, Kariya-shi, Aichi-ken (JP)
(72) Inventor: Kato, Yoshifumi, Kariya-shi, Aichi-ken (JP); Noritake, Kazuto, Kariya-shi, Aichi-ken (JP)
(74) Representative: Leson, Thomas Johannes Alois, Dipl.-Ing.

(57) **Abstract**

A display of the present invention includes a transmissive liquid crystal panel (1) and a backlight panel (10). Outside light that is irradiated on to the display is reflected by a reflective electrode (13) located in the backlight panel. The reflected outside light is scattered by a scattering portion (21) located in the backlight panel and returns to the liquid crystal panel. This improves the quality of an image displayed on the screen.

## Description

### BACKGROUND OF THE INVENTION

The present invention relates to a lighting system and a display.

Liquid crystal displays (LCD) are classified broadly into transmissive LCDs, reflective LCDs, and transflective LCDs. A transmissive LCD includes a lighting unit that functions as a backlight. The transmissive LCD displays a highly clear image indoors but displays a less clear image outdoors since the contrast of the image deteriorates. A reflective LCD, which has a reflective element, displays a highly clear image outdoors but displays a less clear image indoors since the contrast of the image is insufficient. An image displayed by a transflective LCD outdoors is clearer than an image displayed by the transmissive LCD outdoors but is less clear than an image displayed by the reflective LCD outdoors. An image displayed by a transflective LCD indoors is clearer than an image displayed by the reflective LCD indoors but is less clear than an image displayed by the transmissive LCD indoors.

A transmissive LCD that includes a lighting unit, which is provided with a reflective element having light reflectivity, has been proposed to display a highly clear image outdoors. More specifically, in a lighting unit, which has an electroluminescent element, one of a pair of electrodes used for applying an electric field to the electroluminescent element is suggested to be formed of metal, which has light reflectivity. In this case, outside light reflected by the reflective element is used for displaying an image. Thus, the LCD can display a highly clear image outdoors without actuating the lighting unit.

However, when the reflective element is made of metal, an image displayed using light reflected by the reflective element has a metallic luster. Therefore, the image quality deteriorates. For example, a displayed image might seem to exist in a mirror, or an outside light source might be reflected on a screen where an image is displayed.

### SUMMARY OF THE INVENTION

Accordingly, it is an objective of the present invention to provide a display that displays a high quality image and a lighting system that is mounted on the display.

To achieve the above objective, the present invention provides a lighting system, which includes a light emitting element, a reflective element, an output element, and a scattering portion. The light emitting element is located between the reflective element and the output element. The reflective element reflects light that arrives at the reflective element. The output element permits transmission of outside light that arrives at the output element. The output element outputs outside light reflected by the reflective element and light emitted by the light emitting element. The scattering portion is located between the reflective element and the output element. The scattering portion scatters light that arrives at the scattering portion.

The present invention also provides a display, which includes a lighting unit and a display unit. The lighting unit includes a light emitting element and a scattering portion. The light emitting element is located between a reflective element and an output element. The reflective element reflects light that arrives at the reflective element. The output element permits transmission of outside light that arrives at the output element. The output element outputs outside light reflected by the reflective element and light emitted by the light emitting element. The scattering portion is located between the reflective element and the output element. The scattering portion scatters light that arrives at the scattering portion. The display unit is located on the output element. The display unit displays an image using light output from the output element.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a schematic exploded perspective view illustrating a section of the display according to a preferred embodiment of the present invention;
Fig. 2 is a schematic cross-sectional view illustrating a backlight panel of the display shown in Fig. 1;
Fig. 3 is a schematic cross-sectional view illustrating part of a display according to a modified embodiment of the present invention;
Fig. 4 is a schematic cross-sectional view illustrating a backlight panel according to another modified embodiment of the present invention;
Fig. 5 is a schematic cross-sectional view illustrating a backlight panel according to a further modified embodiment of the present invention; and
Fig. 6 is a schematic cross-sectional view illustrating a backlight panel according to another modified embodiment of the present invention.

### DETAILED DESCRIPTION OF THE PREFERRED EMBODIMENTS

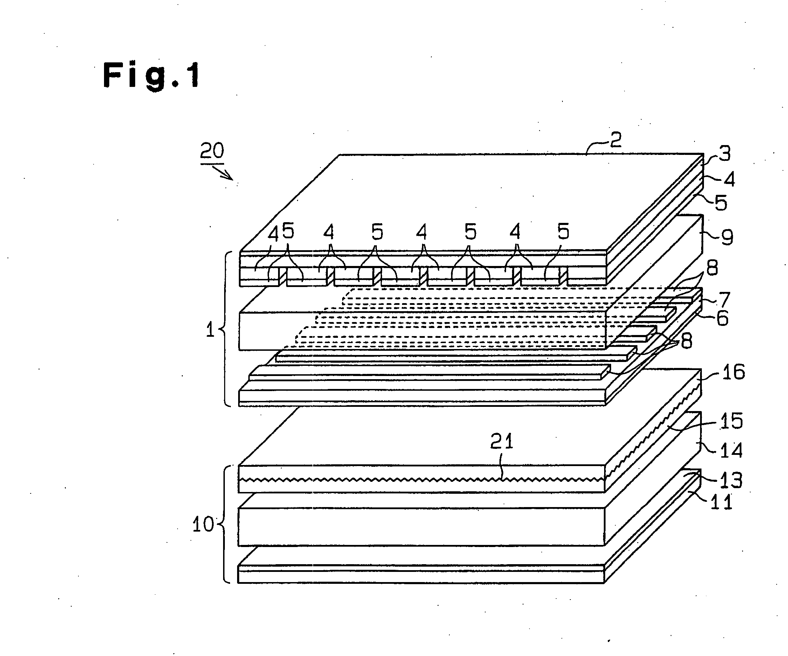

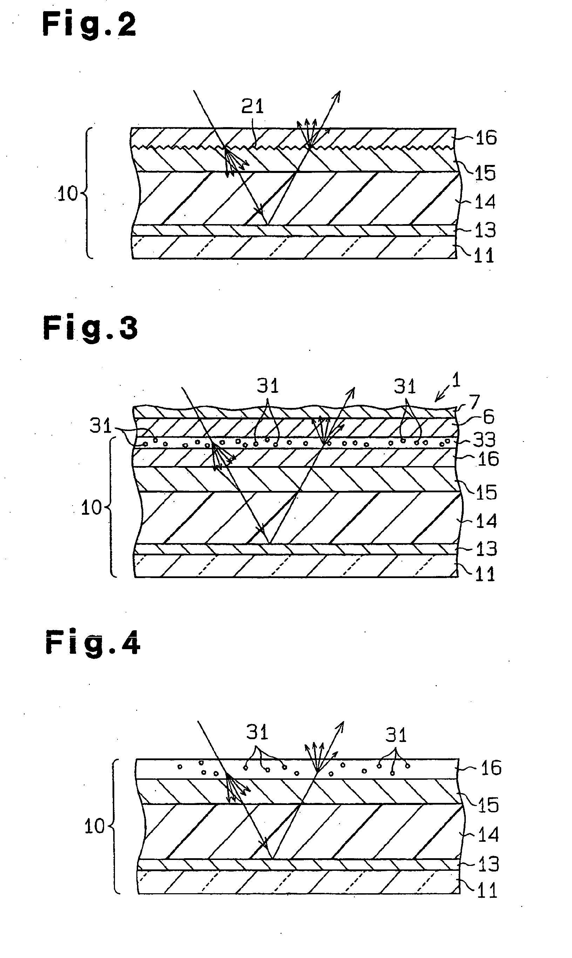

A first embodiment of the present invention will now be described with reference to Figs. 1 and 2. For convenience of illustration, the dimensional ratio among members shown in Fig. 1 and 2 related to the thickness direction of a display 20 differs from the actual dimensional ratio.

As shown in Fig. 1, the display 20 includes a transmissive liquid crystal panel 1 and a backlight panel 10. The liquid crystal panel 1 functions as a display unit, and the backlight panel 10 functions as a lighting unit.

The liquid crystal panel 1 includes liquid crystal elements, which are driven by a passive matrix system. The surface of the liquid crystal panel 1 that is facing away from the backlight panel 10 functions as a screen for displaying an image. The liquid crystal panel 1 has a pair of polarizing plate 2, 6, a pair of substrate 3, 7, color filters 4, transparent electrodes 5, scanning electrodes 8, and a liquid crystal 9.

The substrate 7 is closer to the backlight panel 10 than the substrate 3. The peripheral portions of the substrates 3, 7 are bonded together with a sealing material (not shown). The liquid crystal 9 is located between the substrates 3 and 7.

The polarizing plate 2 is located on the surface of the substrate 3 that is facing away from the liquid crystal 9. The color filters 4 are located on the surface of the substrate 3 that faces the liquid crystal 9. The color filters 4 extend parallel to each other. The color filters 4 include red filters that convert white light to red light, green filters that convert white light to green light, and blue filters that convert white light to blue light. Each transparent electrode 5 is located on the surface of one of the color filters 4 that faces the liquid crystal 9. The transparent electrodes 5 extend parallel to each other.

The polarizing plate 6 is located on the surface of the substrate 7 that is facing away from the liquid crystal 9. The scanning electrodes 8 are located on the surface of the substrate 7 that faces the liquid crystal 9. The scanning electrodes 8 extend parallel to each other and perpendicular to a direction in which the color filters 4 and the transparent electrodes 5 extend.

Portions of the liquid crystal 9 located between the transparent electrodes 5 and the scanning electrodes 8, in other words, portions of the liquid crystal 9 corresponding to intersections between the transparent electrodes 5 and the scanning electrodes 8, function as the liquid crystal elements. The liquid crystal elements are arranged in a matrix. A pixel includes one of the liquid crystal elements corresponding to the red filter, one of the liquid crystal elements corresponding to the green filter, and one of the liquid crystal elements corresponding to the blue filter.

The arrangement of liquid crystal molecules of each liquid crystal element reversibly varies in accordance with an electric field that acts on the liquid crystal element. That is, the arrangement of the liquid crystal molecules of each liquid crystal element varies to prevent light from being transmitted when the electric field that acts on the liquid crystal element is greater than or equal to a predetermined value, and varies to permit light to be transmitted when the electric field that acts on the liquid crystal element is less than the predetermined value. Each liquid crystal element is exposed to an electric field when voltage is applied to the corresponding transparent electrode 5 and the corresponding scanning electrode 8 by a drive apparatus, which is not shown.

The substrates 3, 7 are of a light transmittance type and can be made of transparent glass. The transparent electrodes 5 and the scanning electrodes 8 are of a light transmittance type and can be made of indium tin oxide.

The backlight panel 10 shown in Figs. 1 and 2 is located behind the liquid crystal panel 1. The backlight panel 10 includes an electroluminescent element functioning as a light emitting element. The surface of the backlight panel 10 that faces the liquid crystal panel 1 functions as a light outputting surface, which is an output element that outputs light toward the liquid crystal panel 1. The backlight panel 10 has a substrate 11, a reflective element, which is a reflective electrode 13 in this embodiment, an electroluminescent layer 14, a transparent electrode 15, and a passivation film 16.

The reflective electrode 13 is located on the surface of the substrate 11 that faces the liquid crystal panel 1 and functions as a cathode. The electroluminescent layer 14 is located on the surface of the reflective electrode 13 that faces the liquid crystal panel 1. The transparent electrode 15 is located on the surface of the electroluminescent layer 14 that faces the liquid crystal panel 1 and functions as an anode. The passivation film 16 is located on the surface of the transparent electrode 15 that faces the liquid crystal panel 1. The passivation film 16 prevents transmittance of moisture and oxygen, thereby sealing the electroluminescent layer 14.

The reflective electrode 13 entirely covers the surface of the electroluminescent layer 14 that faces away from the liquid crystal panel 1. The transparent electrode 15 entirely covers the surface of the electroluminescent layer 14 that faces the liquid crystal panel 1.

The electroluminescent layer 14 includes an organic electroluminescent material and functions as the electroluminescent element. The electroluminescent layer 14 includes, for example, an electron transport layer, an illuminating layer, and a hole transport layer. When exposed to an electric field that is greater than a predetermined value, the electroluminescent layer 14 emits white light. The electroluminescent layer 14 is exposed to an electric field when voltage is applied to the reflective electrode 13 and the transparent electrode 15 by a drive apparatus, which is not shown.

The substrate 11 can be made of glass. The reflective electrode 13 has light reflectivity and can be made of metal, such as aluminum or chrome. The transparent electrode 15 is of a light transmittance and can be made of indium tin oxide. The electroluminescent layer 14 and the passivation film 16 are of a light transmittance type.

As shown in Fig. 2, an interface 21 between the transparent electrode 15 and the passivation film 16 has scattering bodies, which are minute concavities and convexities in this embodiment. Therefore, the interface 21 functions as a scattering portion, which scatters light that arrives at the interface 21. The height of the concavities and convexities is less than the thickness of the transparent electrode 15 and the passivation film 16. For example, the height of the concavities and convexities is less than a tenth part of the thickness of the transparent electrode 15 and the passivation film 16.

The backlight panel 10 is manufactured by depositing the reflective electrode 13, the electroluminescent layer 14, and the transparent electrode 15 on the substrate 11 in this order. Then, concavities and convexities are formed on the surface of the transparent electrode 15. Finally, the passivation film 16 is deposited on the transparent electrode 15, which has the concavities and convexities.

An operation of the display 20 will now be described.

The display 20 operates in transmittance and reflectance modes. In the transmittance mode, the display 20 uses light emitted by the backlight panel 10 to show an image on the screen of the liquid crystal panel 1. In the reflectance mode, the display 20 uses the outside light to show an image on the screen.

In the transmittance mode, the backlight panel 10 is activated. When electricity is supplied to the backlight panel 10, voltage is applied to the reflective electrode 13 and the transparent electrode 15, which causes the electroluminescent layer 14 to emit white light. The emitted light exits from the light outputting surface and is irradiated onto the liquid crystal panel 1. Light that is irradiated onto portions of the liquid crystal panel 1 that correspond to liquid crystal elements permitting transmission of light passes through the liquid crystal 9. The passed through light is then converted into red light, green light, or blue light by the color filters 4. As a result, an image is shown on the screen of the liquid crystal panel 1.

In the reflectance mode, the backlight panel 10 is not activated. The outside light that enters the display 20 reaches the reflective electrode 13. Then that light is reflected by the reflective electrode 13. The reflected light exits from the light outputting surface and is irradiated onto the liquid crystal panel 1. Light that is irradiated onto portions of the liquid crystal panel 1 that correspond to liquid crystal elements permitting transmission of light passes through the liquid crystal 9. The passing through light is then converted into red light, green light, or blue light by the color filters 4. As a result, an image is shown on the screen of the liquid crystal panel 1.

The preferred embodiment provides the following advantages.

Since the reflective electrode 13 is made of metal, an image displayed using the light reflected by the reflective electrode 13 normally has a metallic luster. However, the light reflected by the reflective electrode 13 is scattered by the concavities and convexities on the interface 21 when passing through the interface 21 between the transparent electrode 15 and the passivation film 16. This reduces the metallic luster of an image displayed using light reflected by the reflective electrode 13, which improves the clearness of the image.

The display 20, which displays an image using scattered light, has a wider viewing angle as compared to a conventional liquid crystal display which displays an image using non-scattered light.

The outside light that enters the display 20 passes through the interface 21 twice, that is, before and after being reflected by the reflective electrode 13. Accordingly, the outside light is scattered twice. The light that is scattered twice has a greater degree of scattering than the light that is scattered once. That is, an image displayed using light that is scattered before and after being reflected by the reflective electrode 13 has less metallic luster than an image displayed using light that is scattered only either before or after being reflected by the reflective electrode 13. Accordingly, the display 20, which displays an image using light that is scattered twice, displays an image that has an improved clearness as compared to a display that displays an image using light that is scattered once.

In the preferred embodiment, the interface 21 between the transparent electrode 15 and the passivation film 16 functions as the scattering portion. Therefore, the display 20 is permitted to use scattered light for displaying an image without increasing the thickness of the backlight panel 10.

The backlight panel 10 has a top emission structure in which the electroluminescent layer 14 is located closer to the light outputting surface than the substrate 11 but not a bottom emission structure in which the substrate 11 is located closer to the light outputting surface than the electroluminescent layer 14. In the case with the backlight panel 10, which has the top emission structure, light emitted by the electroluminescent layer 14 is not damped as much as a backlight panel that has the bottom emission structure before being output from the light outputting surface.

The single electroluminescent element of the backlight panel 10 radiates light toward the pixels of the liquid crystal panel 1. The backlight panel 10 that includes single electroluminescent element has a simple structure as compared to a backlight panel that has several electroluminescent elements.

It should be apparent to those skilled in the art that the present invention may be embodied in many other specific forms without departing from the spirit or scope of the invention. Particularly, it should be understood that the invention may be embodied in the following forms.

An interface between the passivation film 16 and the polarizing plate 6 may have minute concavities and convexities instead of the interface 21 between the transparent electrode 15 and the passivation film 16. In this modified embodiment, the interface between the passivation film 16 and the polarizing plate 6 functions as the scattering portion.

An interface between the electroluminescent layer 14 and the transparent electrode 15 may have minute concavities and convexities instead of the interface 21 between the transparent electrode 15 and the passivation film 16. In this modified embodiment, the interface between the electroluminescent layer 14 and the transparent electrode 15 functions as the scattering portion.

An interface between the electroluminescent layer 14 and the reflective electrode 13 may have minute concavities and convexities instead of the interface 21 between the transparent electrode 15 and the passivation film 16. In this modified embodiment, the interface between the electroluminescent layer 14 and the reflective electrode 13 functions as the scattering portion. However, the modified embodiment differs from the embodiment of Figs. 1 and 2 in that the outside light that is irradiated onto the display 20 is scattered only once.

The backlight panel 10 may have two or more portions of the backlight panel 10 that function as scattering portions. For example, the surface of the passivation film 16 that is facing away from the transparent electrode 15 may have minute concavities and convexities in addition to the interface 21 between the transparent electrode 15 and the passivation film 16.

As shown in Fig. 3, the liquid crystal panel 1 may be adhered to the backlight panel 10 using transparent adhesive that includes scattering bodies, which are minute particles 31 like beads in this embodiment. In other words, a transparent adhesive layer 33, which includes the minute particles 31, may be formed on the surface of the passivation film 16 that faces the liquid crystal panel 1. In this modified embodiment, the transparent adhesive layer 33 functions as the scattering portion. According to this modified embodiment, the portion of the backlight panel 10 that functions as the scattering portion is easily manufactured as compared to the embodiment of Figs. 1 and 2. The particle size of the minute particles 31 is smaller than the thickness of the transparent electrode 15 and the passivation film 16. For example, the particle size of the minute particles 31 is less than a tenth part of the thickness of the transparent electrode 15 and the passivation film 16.

Alternatively, the transparent adhesive layer 33 may be located between the transparent electrode 15 and the passivation film 16.

As shown in Fig. 4, the passivation film 16 may include the minute particles 31. In this modified embodiment, the passivation film 16 functions as a scattering portion. According to this modified embodiment, the display 20 is permitted to use scattered light for displaying an image without increasing the thickness of the backlight panel 10. To form the passivation film 16, which includes the minute particles 31, part of the passivation film 16 is deposited on the transparent electrode 15. The minute particles 31 are then spread on the part of the passivation film 16. After spreading the minute particles 31, the remaining of the passivation film 16 is deposited on the part of the passivation film 16 on which the minute particles 31 are spread.

The transparent electrode 15 may include the minute particles 31. In this modified embodiment, the transparent electrode 15 functions as the scattering portion.

The electroluminescent layer 14 may include the minute particles 31. In this modified embodiment, the electroluminescent layer 14 functions as the scattering portion.

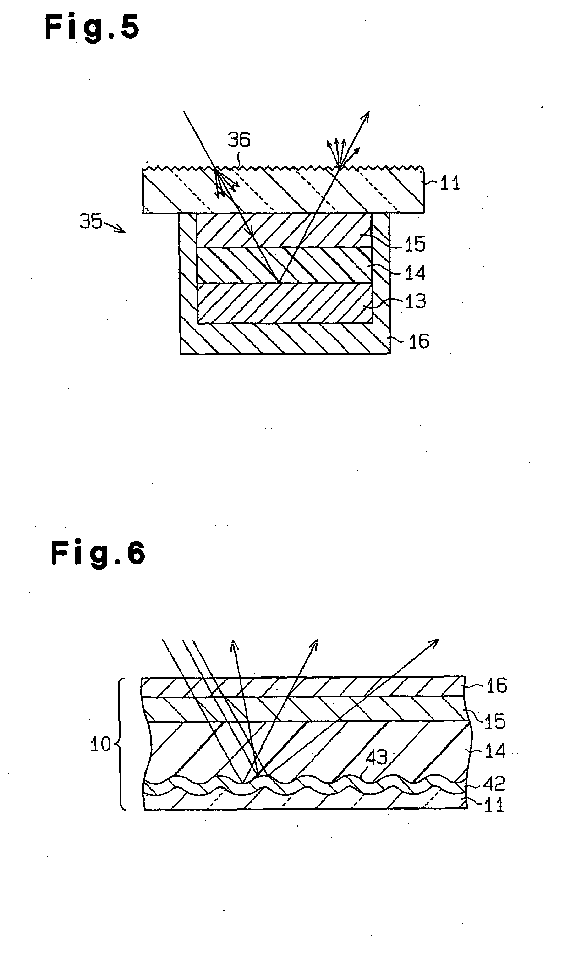

The backlight panel 10 may be replaced with, for example, a backlight panel 35, which has a bottom emission structure, as shown in Fig. 5. The backlight panel 35 is formed by laminating the transparent electrode 15, the electroluminescent layer 14, the reflective electrode 13, and the passivation film 16 on the rear surface of the substrate 11 in this order. A surface 36 of the substrate 11 that is facing away from the transparent electrode 15 has minute concavities and convexities. In this modified embodiment, the surface 36 functions as the scattering portion.

The surface of the substrate 11 that faces the transparent electrode 15 of the backlight panel 35 shown in Fig. 5 may have minute concavities and convexities. In this modified embodiment, the interface between the substrate 11 and the transparent electrode 15 functions as the scattering portion.

The interface between the transparent electrode 15 and the electroluminescent layer 14 of the backlight panel 35 shown in Fig. 5 may have minute concavities and convexities. In this modified embodiment, the interface between the transparent electrode 15 and the electroluminescent layer 14 functions as the scattering portion.

The interface between the electroluminescent layer 14 and the reflective electrode 13 of the backlight panel 35 shown in Fig. 5 may have minute concavities and convexities. In this modified embodiment, the interface between the electroluminescent layer 14 and the reflective electrode 13 functions as the scattering portion.

The substrate 11, the transparent electrode 15, or the electroluminescent layer 14 of the backlight panel 35 shown in Fig. 5 may include the minute particles 31. In this modified embodiment, the substrate 11, the transparent electrode 15, or the electroluminescent layer 14 functions as the scattering portion.

A backlight panel that has the bottom emission structure may be adhered to the liquid crystal panel 1 using transparent adhesive that includes minute particles. In this modified embodiment, a layer formed of the transparent adhesive functions as the scattering portion.

The backlight panel 10 shown in Fig. 2 may be replaced with the backlight panel 10 shown in Fig. 6. The backlight panel 10 of Fig. 6 has the top emission structure and includes a corrugated reflective electrode 42. In this modified embodiment, the interface between the electroluminescent layer 14 and the reflective electrode 42 functions as the scattering portion. The angle between an imaginary straight line, which connects the adjacent vertex and the valley located on the front surface of the reflective electrode 42, and the rear surface of the substrate 11 is preferably less than or equal to 10 degrees.

The backlight panel 10 shown in Fig. 2 may be replaced with a backlight panel that has a bottom emission structure and includes a corrugated reflective electrode.

The reflective electrode 13 of the backlight panel 10 shown in Fig. 2 may be replaced with an electrode that is of a light transmittance type. In this case, a reflective film having a light reflectivity, such as a metallic film, needs to be located on the front or rear surface of the substrate 11.

The passivation film 16 of the backlight panel 10 shown in Fig. 2 may be replaced with, for example, a glass plate. In this case, the glass plate and the substrate 11 need to be sealed with sealing material, such as epoxy resin.

The passivation film 16 of the backlight panel 35 shown in Fig. 5 may be replaced with, for example, a metallic sealing cover.

The reflective electrode 13 may function as an anode, and the transparent electrode 15 may function as a cathode.

The liquid crystal panel 1 may be replaced with a liquid crystal panel includes liquid crystal elements, which are driven by an active matrix system.

The backlight panel 10 may be replaced with a backlight panel that has several electroluminescent elements, which emit light independently from each other. In this modified embodiment, the electroluminescent elements that correspond to the liquid crystal elements that permit light transmission are controlled to emit light. This reduces power consumption.

The present invention need not be applied to a lighting unit for a display. For example, the present invention may be applied to room lamps of automobiles or lighting equipment used indoors.

The present examples and embodiments are to be considered as illustrative and not restrictive and the invention is not to be limited to the details given herein, but may be modified within the scope and equivalence of the appended claims.

A display of the present invention includes a transmissive liquid crystal panel and a backlight panel. Outside light that is irradiated on to the display is reflected by a reflective electrode located in the backlight panel. The reflected outside light is scattered by a scattering portion located in the backlight panel and returns to the liquid crystal panel. This improves the quality of an image displayed on the screen.

## Claims

1. A lighting system **characterized by**:
a light emitting element located between a reflective element and an output element, wherein the reflective element reflects light that arrives at the reflective element, wherein the output element permits transmission of outside light that arrives at the output element, and wherein the output element outputs outside light reflected by the reflective element and light emitted by the light emitting element; and
a scattering portion located on the reflective element or between the reflective element and the output element, wherein the scattering portion scatters light that arrives at the scattering portion.

2. The lighting system according to claim 1, **characterized in that** the scattering portion is located on part of the lighting system other than the reflective element.

3. The lighting system according to claim 2, **characterized in that** the scattering portion is located between the light emitting element and the output element.

4. The lighting system according to any one of claims 1 to 3, **characterized in that** the scattering portion is an interface between two of the elements of the lighting system, which interface has scattering bodies, and wherein the scattering bodies are minute concavities and convexities.

5. The lighting system according to any one of claims 1 to 3, **characterized in that** the scattering portion is a layer, which includes scattering bodies, and wherein the scattering bodies are minute particles.

6. The lighting system according to any one of claims 1 to 5, **characterized by** a substrate, wherein the light emitting element is located between the substrate and the output element.

7. The lighting system according to any one of claims 1 to 6, **characterized in that** the light emitting element is formed as a sheet.

8. The lighting system according to any one of claims 1 to 7, **characterized in that** the light emitting element is an electroluminescent element.

9. The lighting system according to claim 8, **characterized in that** the reflective element and the output element are electrodes, and wherein the electroluminescent element performs electroluminescence when a voltage is applied to the electrodes.

10. The lighting system according to claim 9, **characterized in that** the entire electroluminescent element emits light when a voltage is applied to the electrodes.

11. The lighting system according to any one of claims 8 to 10, **characterized in that** the electroluminescent element includes an organic electroluminescent material.

12. A display **characterized by**;
a lighting unit, wherein the lighting unit includes:
a light emitting element located between a reflective element and an output element, wherein the reflective element reflects light that arrives at the reflective element, wherein the output element permits transmission of outside light that arrives at the output element, and wherein the output element outputs outside light reflected by the reflective element and light emitted by the light emitting element; and
a scattering portion located on the reflective element or between the reflective element and the output element, wherein the scattering portion scatters light that arrives at the scattering portion; and
a display unit located on the output element, wherein the display unit displays an image using light output from the output element.

13. The display according to claim 12, **characterized in that** the display unit includes a plurality of liquid crystal elements.

14. The display according to claim 12 or 13, **characterized in that** the scattering portion is an interface between two of the elements of the lighting unit, which interface has scattering bodies, and wherein the scattering bodies are minute concavities and convexities.

15. The display according to claim 12 or 13, **characterized in that** the scattering portion is a layer, which includes scattering bodies, and wherein the scattering bodies are minute particles.

16. The display according to claim 15, **characterized in that** the layer further includes an adhesive, and wherein the layer attaches the lighting unit to the display unit.

17. The display according to any one of claims 12 to 16, **characterized in that** the light emitting element is an electroluminescent element.

18. The display according to claim 17, **characterized in that** the electroluminescent element includes an organic electroluminescent material.
